# EUROPEAN PATENT APPLICATION

(11) **EP 4 068 809 A1**
(43) Date of publication of application: **05.10.2022**
(21) Application number: 22158711.6
(22) Date of filing: 25.02.2022
(51) Int. Cl.: H04S 7/00, G10L 21/0316, H03G 3/32, G10L 25/78

(54) **SMART HOME APPLIANCE AND AUDIO CONTROL METHOD THEREOF**

(30) Priority: 02.04.2021 TR 202105960
(71) Applicant: Arçelik Anonim Sirketi, 34445 Istanbul (TR)
(72) Inventor: KILICKAYA, Ali Bekir, 34445 ISTANBUL (TR); DEMIREL, Ibrahim, 34445 Istanbul (TR); OZEL, Alper, 34445 Istanbul (TR)

(57) **Abstract**

The present invention relates to a smart home appliance (1) for playing audio content and an audio control method for the smart home appliance (1). The smart home appliance (1) comprises: a far-field module (2) for picking up played audio content sound and ambient sound, and detecting presence of speech in ambient sound; a sound analysis unit (3) for analysing picked-up sounds and determining audio modification parameters according to the analysis; a real-time sound processor (4) for processing audio content according to said audio modification parameters; and at least one loudspeaker (5) for outputting processed audio content.

## Description

The present invention relates to a smart home appliance and an audio control method for the smart home appliance.

Content sounds played by home appliances may interfere with conversations between people in the same environment. In order to enhance comprehensibility of speech, people in conversation need to speak louder or adjust volume of the home appliance manually. Some smart home appliances such as smart televisions or intelligent loudspeakers have "automatic audio ducking" functionality wherein volume of audio content played by the appliance is automatically controlled in response to ambient sounds detected by the appliance. In most cases said audio ducking feature is designed to control audio settings in immediate response to changes in ambient sounds, such as a voice command, which may cause frequent fluctuations and rapid changes in the level of audio output and may cause negative user experience.

In the state of the art, United States patent application US2018091913A1 discloses techniques for controlling audio playback settings for voice interaction. A playback device, upon detecting an anticipated playback of an audio in the environment, determines loudness of background noise and ducks the playback sound accordingly.

The aim of the present invention is to overcome the shortcomings of prior art by realization of a smart home appliance and an audio control method thereof, wherein audio content played by the smart appliance is intelligently controlled in order to enhance comprehensibility of a speech in the same environment. Another purpose of the present invention is to provide a smart appliance and audio attenuation method wherein unnecessary and abrupt changes in audio level in response to ambient sounds is prevented.

The smart home appliance realized in order to attain the aim of the present invention, explained in Claim 1 and the respective claims thereof, comprises a far-field module for picking up played audio content sound and ambient sound, and detecting presence of speech in ambient sound; a sound analysis unit for analysing picked-up sounds and determining audio modification parameters according to the analysis; a real-time sound processor for processing audio content according to said audio modification parameters; and at least one loudspeaker for outputting processed audio content

In the preferred embodiment of the present invention, the sound analysis unit is configured to, if presence of speech in ambient sound is detected, analyse loudness levels of audio content sound and ambient sound over a first predetermined time period; and, if loudness level of audio content sound in the first predetermined time period is higher than the loudness level of ambient sound in the first predetermined time period, determine audio modification parameters to attenuate audio content sound. Alternatively, the sound analysis unit may be configured to determine modification parameters if loudness level of audio content sound in the first predetermined time period is higher than a predetermined percentage of the loudness level of ambient sound in the first predetermined time period, wherein said percentage can be less the 100%, such as 90%, 80% or 75%. As a result, audio content sound is attenuated only when ambient sound is louder than (a predetermined percentage of) the audio content sound over an extended duration. Comprehensibility of speech is enhanced, while eliminating possible fluctuations in the output level of audio content.

In an embodiment, at least one of the far-field module and the sound analysis unit is configured to determine whether speech is detected for at least a second predetermined time period, and the sound analysis unit is further configured to analyse loudness levels only if speech is detected for at least said second predetermined time period. Accordingly, audio content sound is not necessarily modified for momentary changes in the ambient sounds.

According to some embodiments, determining audio modification parameters comprises carrying out a frequency-based analysis of ambient sound in order to determine audio modification parameters.

The frequency-based analysis may comprise, per each one of a plurality of frequency bands, sampling ambient sound signals at a predetermined rate and calculating average minimum and maximum loudness levels of the samples within the first predetermined time period. The frequency-based analysis may further comprise calculating difference between averaged maximum and minimum loudness levels per each one of said plurality of frequency bands. The sound analysis unit may be further configured to determine audio modification parameters based on calculated difference between averaged maximum and minimum loudness levels per each frequency band. Accordingly, it is provided that audio content is not attenuated more than necessitated by the loudness level of ambient sounds and comprehensibility of audio content is maintained as much as possible, while improving comprehensibility of speech in the environment.

In an embodiment of the invention, the sound analysis unit is further configured to select frequency bands for which the difference between averaged maximum and minimum loudness levels is above a threshold value, and determine audio modification parameters based on the calculated difference between averaged maximum and minimum loudness levels for selected frequency bands only. In this way, it is possible to distinguish between varying sounds such as human speech and substantially steady sounds such as background noises, and attenuate the audio content output specifically for frequencies bands corresponding to human speech.

In preferred embodiments, audio modification parameters may comprise numeric values representing a negative gain equalising curve.

The sound analysis unit may be further configured to adjust audio modification parameters such that for none of frequency bands the negative gain value is larger than a predetermined maximum attenuation value. Said predetermined maximum attenuation value may be set and adjusted by the user of home appliance. Accordingly, a maximum attenuation level and hence a minimum output level of audio content may be maintained in accordance with user preferences.

The smart home appliance may be any appliance for playing audio content and comprising means for picking up ambient sounds. The smart home appliance may be a smart television or an intelligent loudspeaker.

According to another aspect of the present invention, there is provided an audio control method for the smart home appliance. The method comprises: starting playing audio content on the smart home appliance; picking up played audio content sound and ambient sound; detecting whether speech is present in ambient sound; analysing, if presence of speech in ambient sound is detected, loudness levels of audio content sound and ambient sound over a first predetermined time period; comparing loudness levels of audio content sound and ambient sound in the first predetermined time period; determining, if loudness level of audio content sound is higher than a predetermined percentage, e.g. 100% of the loudness level of ambient sound, audio modification parameters to attenuate audio content signals; processing audio content according to said audio modification parameters; and outputting processed audio content.

Determining audio modification parameters may comprise carrying out a frequency-based analysis of ambient sound. Said frequency-based analysis may comprise, per each one of a plurality of frequency bands: sampling ambient sound signals at a predetermined rate and calculating average minimum and maximum loudness levels of the samples within the first predetermined time period; calculating difference between averaged maximum and minimum loudness levels; and determining audio modification parameters based on the calculated difference per each frequency band.

The frequency-based analysis may further comprise: selecting frequency bands for which the difference between averaged maximum and minimum loudness levels is above a threshold value; and determining audio modification parameters based on the calculated difference for selected frequency bands only.

Any embodiment of the method in accordance with the present invention may be implemented at least partially using software, e.g. computer programs. Any of the steps described in relation to any of the aspects or embodiments of the invention may be carried out under the control of a set of one or more processors. The present invention thus also extends to a computer program comprising computer readable instructions executable to perform, or to cause a device to perform, a method according to any of the aspects or embodiments of the invention.

Thus, in another aspect of the present invention, there is provided computer software operable, when executed on a smart home appliance, to cause one or more processors to perform the audio control method as described above. Accordingly, the inventive features can be easily implemented on any suitable smart home appliance, for example simply by a software update. The computer software may be stored on a non-transitory computer-readable medium.

The smart home appliance and the audio control method realized in order to attain the aim of the present invention is illustrated in the attached figures, where:
Figure 1 is the schematic view of a smart home appliance according to an embodiment of the invention,

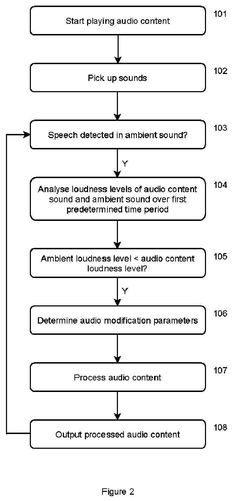

Figure 2 is a flow diagram of an audio control method according to an embodiment of the invention,
Figure 3 is an exemplary graph indicating frequency-based loudness levels of ambient sound, obtained by frequency-based analysis according to an embodiment of the invention,
Figure 4 is an exemplary graph indicating frequency-based negative gain values and an equalising curve shape obtained therefrom according to an embodiment of the invention, and
Figure 5 is an example of an equalising curve before and after scaling, according to an embodiment of the invention.

The elements illustrated in the figures are numbered as follows:
1. Smart home appliance
2. Far-field module
3. Sound analysis unit
4. Real-time sound processor
5. Loudspeaker

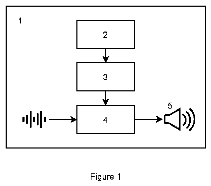

The smart home appliance (1) for playing audio comprises a far-field module (2), or a similar sound detecting means, for picking up sounds around the smart home appliance (1), that is in the environment of the smart home appliance (1), such as in a room. Far field module (2) preferably 'listens' the environment continuously. Sounds picked up by the far-field module (2) may comprise audio content sound played by the smart home appliance (1) and ambient sound. The far-field module (2) is arranged to detect presence of speech in ambient sound. The smart home appliance (1) further comprises a sound analysis unit (3) for analysing picked-up sounds and determining audio modification parameters according to the analysis; a real-time sound processor (4) for processing audio content according to said audio modification parameters; and at least one loudspeaker (5) for outputting processed audio content. (Figure 1)

The far-field module (2) preferably extracts played back audio content sound from the picked-up sounds, and sends the played back audio content sound and ambient sound information to the sound analysis unit (3) separately. The sound analysis (3) analyses the loudness levels of audio content sound and ambient sound, and when necessary, determines audio modification parameters continuously. Audio modification parameters determined by the sound analysis unit (3) is then applied to the audio content signals by the real-time sound processor (4) in order to be output by one or more loudspeakers (5). The real-time sound processor (4) preferably processes the audio content in line with audio modification parameters such that changes from the currently played audio content to modified audio content occurs gradually, preferably along a transition time. This ensures that users of the smart home appliance (1) do not hear rapid increases or decreases in the level of sound output from the loudspeaker (5).

In a preferred embodiment, the sound analysis unit (3) is configured to, provided that presence of speech in ambient sound is detected by the far-field module (2), analyse loudness levels of audio content sound and ambient sound over a first predetermined time period. The sound analysis unit (3) is further configured to, if loudness level of audio content sound in the first predetermined time period is higher than a predetermined percentage (e.g. 100% or 80%) of the loudness level of ambient sound in the first predetermined time period, determine audio modification parameters to attenuate audio content sound so that comprehensibility of speech in the same environment is increased. Said percentage used in the comparison, which may be preset to 100%, can be adjusted or otherwise selected automatically by the sound analysis unit (3) and/or by the user of the smart home appliance (1).The loudness levels of audio content sound and ambient sound compared before determining audio modification parameters may be the averaged loudness levels of said sounds along the first predetermined time period.

The first predetermined time period is chosen to be an extended time which allows ignoring momentary ambient sounds with short durations, for example shorter than 5 seconds; but allowing detection of an ongoing speech or conversation. Thus, said first predetermined time period may be 5 seconds or more, preferably between 5 and 30 seconds, for example 5, 10, 15, 20 or 30 seconds.

For this purpose, the far-field module (2) or the sound analysis unit (3) may be further configured to determine whether speech is detected for at least a second predetermined time period, and sound analysis unit (3) is further configured to analyse loudness levels only if speech is detected for at least said second predetermined time period. The second predetermined time period may be equal to or different from the first predetermined time period. The second predetermined time period may also be 5 seconds or more, preferably between 5 and 30 seconds, for example 5, 10, 15, 20 or 30 seconds.

If a speech or a speech lasting for at least second predetermined time period is not determined in the ambient sound, or if loudness level of audio content sound in the first predetermined time period is not higher than a predetermined percentage of the loudness level of ambient sound in the first predetermined time period; then the original audio content without modifications is output. In other words, if the content audio being output at that time is already the original audio content, then no changes are made. If, however, the content audio being output at that time is modified audio content, then all changes are reset, preferably gradually, and original audio content is played unless a change in ambient sound which requires an audio modification in response occurs.

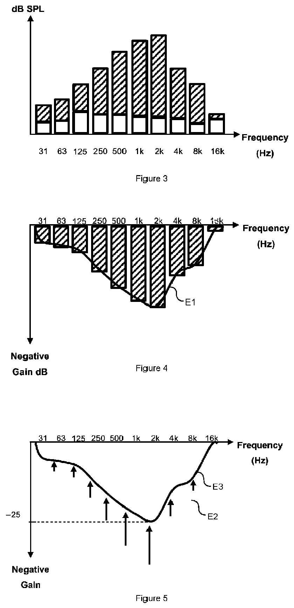

In some embodiments, determining audio modification parameters comprises carrying out a frequency-based analysis of ambient sound in order to determine audio modification parameters. For purposes of frequency-based analysis, the sound analysis unit (3) may record and/or analyse the ambient sounds at a plurality of frequency bands of a given octave band, and average the sound levels periodically. The frequency-based analysis may comprise, per each one of a plurality of frequency bands, sampling ambient sound signals at predetermined intervals preferably between 1-5 seconds (e.g. every second or every 2, 3, 4 or 5 seconds) and calculating average of obtained minimum and maximum loudness levels of the samples within the first predetermined time period (e.g. 10, 15, 20, 30 seconds). The frequency-based analysis may further comprise calculating the difference between averaged maximum and minimum loudness levels per each one of said plurality of frequency bands. Figure 3 shows results of an exemplary frequency-based analysis of ambient sound, where each bar in the graph indicates the averaged minimum and maximum loudness levels per corresponding frequency band. Differences between respective maximum and minimum levels are shown with filler patterns.

The difference between averaged maximum and minimum loudness levels per plurality of frequency bands is used in determining audio modification parameters. For this purpose, the sound analysis unit (3) is further configured to determine audio modification parameters based on these differences. As illustrated in Figure 4, determining audio modification parameters may comprise determining numeric values such as negative gain values per frequency band, representing a negative gain equalising curve (E1). Thus, the audio modification parameters determined in this way may result in a negative gain equaliser (E1) generated by negative equivalents of said differences between maxima and minima. In addition to equaliser and multi-band compression/expansion values, audio modification parameters may also comprise limiter, de-esser, de-reverb, and similar values.

According to an embodiment, audio modification parameters are determined based only on calculated differences corresponding to a subset of frequency bands used in the frequency-based analysis. The sound analysis unit (3) is configured to select frequency bands for which the difference between averaged maximum and minimum loudness levels is above a threshold value, and determine audio modification parameters based on the calculated difference between averaged maximum and minimum loudness levels for selected frequency bands only. This may result in, for example, a negative gain equaliser generated by negative equivalents of differences per selected frequency bands. Said threshold value is selected such that loudness variations below the threshold are considered to be constant noise, for example a background noise generated by another appliance, in the ambient sound. Remaining ambient sound components having a loudness variation above the threshold, on the other hand, represent human speech frequency area. Accordingly, audio content sound is attenuated specifically for frequency bands corresponding to speech in the environment.

Sound analysis unit (3) may further be configured to adjust audio modification parameters such that for none of said frequency bands the negative gain value is larger than a predetermined maximum attenuation value. This value can be set and adjusted by user of the smart home appliance. Sound analysis unit (3) checks whether the maximum negative gain value per an equalising curve is above the maximum attenuation value. If this is the case, then the equalising curve is scaled down to fit within the maximum attenuation value. This is illustrated in Figure 5, where the maximum attenuation value is -25 dB and the maximum negative gain value of the initial (i.e. unscaled) equalising curve (E2) is around -45 dB. The initial equalising curve (E2) is then scaled down according to the maximum value of -25 dB. In this way, a new scaled equalising curve (E3) satisfying the maximum attenuation value, as well as maintaining the frequency-based attenuation characteristics, is obtained.

The audio control method comprises: starting playing (101) audio content on the smart home appliance (1); picking up (102), by the far field module (2) sounds around the smart home appliance (1), which comprise played audio content sound and ambient sound; and detecting (103), by the far-field module (2), whether speech is present in ambient sound.

If no speech is detected in ambient sound, it is decided that there is no interference between a speech in the environment and the audio content sound played by the smart home appliance (1). Hence, audio modifications made earlier, if any, are reset smoothly, and original audio content sound is played back. The method goes back to the step of picking up (102) sounds, that is, listening to the environment and waiting presence of speech confirmation from the far-field module (2).

If speech is detected, the method proceeds to analysing (104), by the sound analysis unit (3), loudness levels of audio content sound and ambient sound over a first predetermined time period; and comparing (105), by the sound analysis unit (3), loudness levels of audio content sound and ambient sound in the first predetermined time period.

If loudness level of audio content sound is not higher than a predetermined percentage of the loudness level of ambient sound, it is decided that there is no interference between a speech in the environment and the audio content sound played by the smart home appliance (1). Hence, audio modifications made earlier, if any, are reset smoothly, and original audio content sound is played back. The method goes back to the step of picking up (102) sounds, that is, listening to the environment.

If, as a result of comparison (105), loudness level of audio content sound is found to be higher than a predetermined percentage of the loudness level of ambient sound, the method proceeds with determining (106), by the sound analysis unit (3), audio modification parameters to attenuate audio content signals in order to increase comprehensibility of speech. Then the audio content is processed (107) by the real-time sound processor (4) according to said audio modification parameters, and the processed audio content is output (108) by the loudspeaker (5).

In preferred embodiments of the method, as long as audio content sound is playing, picking up (102) sounds and detecting (103) whether speech is present occurs continuously. According to the audio control method, it is continuously decided whether to analyse (104) the loudness levels over a predetermined time, and upon detecting possible interference with speech by comparing (105) loudness levels, to determine (106) new audio modification parameters. Thus, audio modification parameters such as equaliser and audio compression values are constantly updated the audio content output is modified accordingly, either to apply updated parameters or to reset back to original audio content. Audio content is processed (107) such that said modifications are applied gradually and no rapid changes occur when outputting (108) audio content with updated audio modification parameters.

In at least some embodiments, determining (106) audio modification parameters comprises carrying out a frequency-based analysis of ambient sound. The frequency-based analysis comprises, per each one of a plurality of frequency bands: sampling ambient sound signals at predetermined intervals and calculating average minimum and maximum loudness levels of the samples within the first predetermined time period; calculating difference between averaged maximum and minimum loudness levels; and determining audio modification parameters based on the calculated difference per each frequency band. The frequency-based analysis may further comprise selecting frequency bands for which the difference between averaged maximum and minimum loudness levels is above a threshold value, and determining audio modification parameters based on the calculated difference for selected frequency bands only. Audio modification parameters determined in this manner may yield a negative gain equaliser generated by negative equivalents of said calculated differences per selected frequency bands.

By means of the smart home appliance (1) and the intelligent audio control method of the present invention, sounds and particularly presence of human speech in a given environment of the smart home appliance (1) can be continuously monitored, and when a possible interference between said speech and played audio content is determined, the audio content sound is controlled automatically in a dynamic manner to enhance comprehensibility and quality of speech, e.g. by other people in the environment. Since the dynamic modification of audio content sounds in response to picked-up sounds is based on a loudness level analysis of sound signals along an extended period of time, an intelligent audio ducking avoiding too many ups and downs is obtained. Furthermore, owing to the above-described frequency-based analysis of ambient sounds, a more customized audio modification taking account of detected speech frequencies and currently played audio content is provided.

## Claims

1. A smart home appliance (1) for playing audio content, comprising: a far-field module (2) for picking up played audio content sound and ambient sound, and detecting presence of speech in ambient sound; a sound analysis unit (3) for analysing picked-up sounds and determining audio modification parameters according to the analysis; a real-time sound processor (4) for processing audio content according to said audio modification parameters; and at least one loudspeaker (5) for outputting processed audio content; **characterised in that** the sound analysis unit (3) is configured to, if presence of speech in ambient sound is detected, analyse loudness levels of audio content sound and ambient sound over a first predetermined time period, and if loudness level of audio content sound in the first predetermined time period is higher than a predetermined percentage of the loudness level of ambient sound in the first predetermined time period, determine audio modification parameters to attenuate audio content sound.

2. The smart home appliance (1) according to claim 1, wherein the far-field module (2) or the sound analysis unit (3) is configured to determine whether speech is detected for at least a second predetermined time period, and sound analysis unit (3) is further configured to analyse loudness levels only if speech is detected for at least said second predetermined time period.

3. The smart home appliance (1) according to claim 1 or 2, wherein determining audio modification parameters comprises carrying out a frequency-based analysis of ambient sound in order to determine audio modification parameters.

4. The smart home appliance (1) according to claim 3, wherein the frequency-based analysis comprises, per each one of a plurality of frequency bands, sampling ambient sound signals at a predetermined rate and calculating average minimum and maximum loudness levels of the samples within the first predetermined time period.

5. The smart home appliance (1) according to claim 4, wherein the frequency-based analysis further comprises calculating difference between averaged maximum and minimum loudness levels per each one of said plurality of frequency bands.

6. The smart home appliance (1) according to claim 5, wherein the sound analysis unit (3) is further configured to determine audio modification parameters based on calculated difference between averaged maximum and minimum loudness levels per each frequency band.

7. The smart home appliance (1) according to claim 5 or 6, wherein the sound analysis unit (3) is further configured to select frequency bands for which the difference between averaged maximum and minimum loudness levels is above a threshold value, and determine audio modification parameters based on the calculated difference between averaged maximum and minimum loudness levels for selected frequency bands only.

8. The smart home appliance (1) according to any one of preceding claims, wherein audio modification parameters comprise numeric values representing a negative gain equalising curve.

9. The smart home appliance (1) according to claim 8, wherein the sound analysis unit (3) is further configured to adjust audio modification parameters such that for none of said frequency bands the negative gain value is larger than a predetermined maximum attenuation value.

10. The smart home appliance (1) according to any one of preceding claims, wherein the smart home appliance (1) is a smart television or an intelligent loudspeaker.

11. An audio control method for a smart home appliance (1) according to any one of claims 1 to 10, wherein the method comprises:
- starting playing (101) audio content on the smart home appliance (1),
- picking up (102) played audio content sound and ambient sound,
- detecting (103) whether speech is present in ambient sound,
- analysing (104), if presence of speech in ambient sound is detected, loudness levels of audio content sound and ambient sound over a first predetermined time period,
- comparing (105) loudness levels of audio content sound and ambient sound in the first predetermined time period,
- determining (106), if loudness level of audio content sound is higher than a predetermined percentage of the loudness level of ambient sound, audio modification parameters to attenuate audio content signals,
- processing (107) audio content according to said audio modification parameters, and
- outputting (108) processed audio content.

12. The audio control method according to claim 11, wherein determining (106) audio modification parameters comprises carrying out a frequency-based analysis of ambient sound, said frequency-based analysis comprising, per each one of a plurality of frequency bands:
- sampling ambient sound signals at a predetermined rate and calculating average minimum and maximum loudness levels of the samples within the first predetermined time period,
- calculating difference between averaged maximum and minimum loudness levels, and
determining audio modification parameters based on the calculated difference per each frequency band.

13. The audio control method according to claim 12, wherein the frequency-based analysis further comprises:
- selecting frequency bands for which the difference between averaged maximum and minimum loudness levels is above a threshold value, and
- determining audio modification parameters based on the calculated difference for selected frequency bands only.

14. Computer software operable, when executed on a smart home appliance (1) according to any one of claims 1 to 10, to cause one or more processors to perform a method according to any one of claims 11 to 13.
